# EUROPÄISCHE PATENTSCHRIFT

(11) **EP 0 573 855 B1**
(45) Veröffentlichungstag und Bekanntmachung des Hinweises auf die Patenterteilung: **05.04.1995**
(21) Anmeldenummer: 93108590.6
(22) Anmeldetag: 27.05.1993
(51) Int. Cl.: C30B 15/00, B02C 19/18, B22F 9/04

(54) **Verfahren zum kontaminationsfreien Zerkleinern von Halbleitermaterial, insbesondere Silicium**
Process for contamination free comminuting of semi-conductor material, especially of silicon
Procédé de broyage sans contamination de matériaux semi-conducteurs, notamment de silicium

(30) Priorität: 27.05.1992 DE 4218283
(43) Veröffentlichungstag der Anmeldung: 15.12.1993
(73) Patentinhaber: Wacker-Chemitronic Gesellschaft für Elektronik-Grundstoffe mbH, D-84489 Burghausen (DE)
(72) Erfinder: Wolf, Andreas, W-8269 Burgkirchen (DE); Köppl, Franz, Dr., W-8261 Erlbach (DE)

(56) Entgegenhaltungen:
- DD-A- 258 186
- DE-A- 3 428 255
- FR-A- 1 423 592
- GB-A- 1 066 848
- GB-A- 1 284 426
- GB-A- 2 178 337

## Beschreibung

Die Erfindung betrifft ein Verfahren zum kontaminationsfreien Zerkleinern von Halbleitermaterial, insbesondere Silicium.

Für die Herstellung von Solarzellen oder elektronischen Bauelementen, wie beispielsweise Speicherelementen oder Mikroprozessoren, wird hochreines Halbleitermaterial benötigt. Die gezielt eingebrachten Dotierstoffe sind die einzigen Verunreinigungen, die ein derartiges Material im günstigsten Fall aufweisen sollte. Man ist daher bestrebt, die Konzentrationen schädlicher Verunreinigungen so niedrig wie möglich zu halten. Häufig wird beobachtet, daß bereits hochrein hergestelltes Halbleitermaterial im Verlauf der weiteren Verarbeitung zu den Zielprodukten erneut kontaminiert wird. So werden immer wieder aufwendige Reinigungsschritte notwendig, um die ursprüngliche Reinheit zurückzuerhalten. Fremdmetallatome, die in das Kristallgitter des Halbleitermaterials eingebaut werden, stören die Ladungsverteilung und können die Funktion des späteren Bauteils vermindern oder zu dessen Ausfall führen. Infolgedessen sind insbesondere Kontaminationen des Halbleitermaterials durch metallische Verunreinigungen zu vermeiden. Dies gilt insbesondere für Silicium, das in der Elektronikindustrie mit deutlichem Abstand am häufigsten als Halbleitermaterial eingesetzt wird. Hochreines Silicium erhält man beispielsweise durch thermische Zersetzung leicht flüchtiger und deshalb einfach über Destillationsverfahren zu reinigender Siliciumverbindungen, wie beispielsweise Trichlorsilan. Es fällt dabei polykristallin in Form von Stäben mit typischen Durchmessern von 70 bis 300 mm und Längen von 500 bis 2500 mm an. Ein großer Teil der Stäbe wird zur Produktion von tiegelgezogenen Einkristallen, von Bändern und Folien oder zur Herstellung von polykristallinem Solarzellengrundmaterial verwendet. Da diese Produkte aus hochreinem, schmelzflüssigem Silicium hergestellt werden, ist es notwendig, festes Silicium in Tiegeln aufzuschmelzen. Um diesen Vorgang möglichst effektiv zu gestalten, müssen großvolumige, massive Siliciumstücke, wie beispielsweise die erwähnten polykristallinen Stäbe, vor dem Aufschmelzen zerkleinert werden. Dies ist üblicherweise immer mit einer oberflächlichen Verunreinigung des Halbleitermaterials verbunden, weil die Zerkleinerung mit metallischen Brechwerkzeugen, wie Backen- oder Walzenbrechern, Hämmern oder Meißeln, erfolgt.

In der Technik gibt es Bestrebungen, Halbleiterstäbe kontaminationsfrei zu zerkleinern. Die ersten Ansätze hierzu finden sich in den Offenlegungsschriften DE-OS 22 62 178 und DE-38 11 091 A1 sowie in der Patentschrift DE-34 28 255 C2, wonach auf thermischem Wege Spannungen im Halbleiterstab erzeugt werden. Dies geschieht beispielsweise durch Aufheizen des Stabes auf Temperaturen von 600 bis 1000°C und anschließendes, rasches Abkühlen in Wasser, oder durch Aufheizen von Stabteilen in einem Mikrowellenofen. Solche thermisch erzeugten Spannungen führen entweder zur direkten Zerkleinerung des Halbleiterstabes oder dekompaktieren ihn zumindest so stark, daß eine weitere Zerkleinerung auch mit weniger kontaminierenden Brechwerkzeugen gelingt, die beispielsweise aus Kunststoff oder Silicium gefertigt sind.

Durch die Einwirkung hoher Temperaturen werden jedoch Diffusionsvorgänge in Gang gesetzt und/oder beschleunigt, so daß zum Nachteil der Reinheit des Halbleitermaterials zumindest ein Teil der oberflächlichen Verunreinigungen, insbesondere Fremdmetalle, ins Innere des Stabes oder der Bruchstücke gelangen und der Oberflächenreinigung entzogen sind. Darüber hinaus bleibt bei den thermischen Zerkleinerungsverfahren eine Abhängigkeit von mechanischen Zerkleinerungswerkzeugen, wenn die Zerkleinerung infolge der thermisch erzeugten Spannungen unzureichend war, und schließlich ist die weitere Zerkleinerung von Brüchstücken, die eine geforderte maximale Grenzgröße noch überschreiten, durch eine erneute thermische Behandlung aufwendig und kostenintensiv.

Die Aufgabe der Erfindung bestand deshalb darin, ein Verfahren anzugeben, mit dem Halbleitermaterial, insbesondere Silicium, kontaminationsfrei und unter Verzicht auf hohe Temperaturen und mechanische Brechwerkzeuge zerkleinert werden kann, und welches auch auf Bruchstücke beliebiger Größe und Form einfach anwendbar ist.

Gelöst wird die Aufgabe durch ein Verfahren mit den Merkmalen des Anspruches 1. Weitere Ausgestaltungen ergeben sich aus den Unteransprüchen.

Überraschenderweise gelingt es, hartsprödes Halbleitermaterial, wie beispielsweise Silicium, mit Hilfe von Stoßwellen kontaminationsfrei zu zerkleinern. Das Zerkleinerungswerkzeug, bestehend aus einem an sich bekannten Generator zur Erzeugung von Stoßwellen hat zu keinem Zeitpunkt einen direkten Kontakt mit dem Halbleitermaterial. Die Stoßwellen werden von ihrem Entstehungsort durch ein flüssiges Medium, vorzugsweise entgastes Wasser höchster Reinheit, übertragen.

Stoßwellen sind beispielsweise durch Sprengladungen, elektrische Entladungen, auf elektromagnetischem oder piezoelektrischem Weg erzeugbar. Für das erfindungsgemäße Verfahren ist es günstig, aber nicht zwingend, Stoßwellen durch die elektrische Entladung zwischen zwei Elektroden im Brennpunkt eines Halbellipsoidreflektors zu erzeugen. Das sich bei der Entladung zwischen den Elektroden ausbildende Plasma führt zu einer sich mit Schallgeschwindigkeit im Übertragungsmedium ausbreitenden, kugelförmigen Stoßwellenfront, die von den Wänden des Reflektors reflektiert und im Brennpunkt eines gedachten, zum Reflektor spiegelsymmetrisch angeordneten Halbellipsoids gebündelt wird. Um diesen Brennpunkt liegt der Fokussierungsbereich des Halbellipsoidreflektors.

Zweckmäßigerweise wird eine wassergefüllte Zerkleinerungskammer bereitgestellt, die im einfachsten Fall ein Wasserbecken sein kann, in das das zu zerkleinernde Halbleitermaterial eingebracht wird. Die Stoßwellen werden in die Zerkleinerungskammer eingekoppelt. Zu diesem Zweck kann sich der Halbellipsoidreflektor in der Zerkleinerungskammer befinden oder er ist an eine ihrer Begrenzungsflächen montiert. Gegebenenfalls wird der Ort der Stoßwellenerzeugung durch eine für Fremdstoffe undurchlässige, stoßwellenübertragende Membran räumlich vom Halbleitermaterial abgetrennt, um es vor Verunreinigungen zu schützen.

Das Halbleitermaterial wird durch die Aufnahme eines Teils der mit der Stoßwellenfront mitgeführten Energie zerkleinert. Die Zerkleinerung ist umso effektiver, je mehr Energie zur Stoßwellenerzeugung aufgewendet wird und je genauer die Position des Halbleitermaterials und der Ort der Stoßwellenfokussierung übereinstimmen. Es ist deshalb anzustreben, aber keinesfalls zwingend (auch nicht-fokussierte Stoßwellen besitzen eine zerkleinernde Wirkung auf Halbleitermaterial), das zu zerkleinernde Halbleitermaterial im Fokussierungsbereich des Halbellipsoidreflektors zu positionieren. Zu diesem Zweck können prinzipiell das Halbleitermaterial selbst oder auch der Halbellipsoidreflektor bewegt werden. Ein weiterer Parameter, der die Effektivität des erfindungsgemäßen Zerkleinerungsverfahrens beeinflußt, ist die Frequenz, mit der aufeinanderfolgende Stoßwellenfronten erzeugt werden. Bei hohen Entladungsenergien muß mit größeren zeitlichen Abständen zwischen den stoßwellenerzeugenden Entladungen gerechnet werden als bei niedrigeren Energien. Es ist daher eine Aufgabe der Verfahrensoptimierung, die Entladungsernergien und die Entladungsfrequenzen auf das angestrebte Zerkleinerungsergebnis abzustimmen.

Zweckmäßigerweise wird das Halbleitermaterial solange Stoßwellen ausgesetzt, bis eine gewünschte Grenzgroße der Bruchstücke erreicht oder unterschritten ist. Vorzugsweise erfolgt die Zerkleinerung des Halbleitermaterials bei niedrigen Temperaturen, insbesondere Raumtemperatur, so daß eine durch hohe Temperaturen induzierte und/oder beschleunigte Diffusion oberflächlich adsorbierter Fremdstoffe, insbesondere Fremdmetalle, weitgehend vermieden wird.

Die Arbeitsflächen der Werkzeuge für den Transport und die Positionierung des Halbleitermaterials sind, um Verunreinigungen auszuschließen, vorzugsweise aus Kunststoff, wie beispielsweise Polyethylen (PE), Polytetrafluorethylen (PTFE) oder Polyvinylidendifluorid (PVDF), oder aus dem Werkstoff, wie das Zerkleinerungsgut selbst, gefertigt. Ebenso hat es sich als günstig erwiesen, die Innenflächen der Zerkleinerungskammer mit Kunststoff auszukleiden.

In einer bevorzugten Ausführungsform des erfindungsgemäßen Verfahrens werden Maßnahmen getroffen, um Bruchstücke im Fokussierungsbereich des Halbellipsoidreflektors zu halten, solange sie noch größer sind als das von der Grenzgröße vorgegebene Maß. Dies kann beispielsweise dadurch geschehen, daß das Halbleitermaterial in ein Kunststoffnetz gepackt und im Ziel der Stoßwellen gehalten wird, wobei kleine Bruchstücke durch die Maschen des Netzes fallen können. Vorzugsweise werden diese Bruchstücke in Behältern aus nicht kontaminierenden Werkstoffen aufgefangen und aus der Zerkleinerungskammer transportiert.

In einer weiteren Ausführungsform des erfindungsgemäßen Verfahrens wird der Halbellipsoidreflektor in zwei oder drei Raumrichtungen beweglich gelagert, so daß der Fokussierungsbereich des Halbellipsoidreflektors auf das zu zerkleinernde Halbleitermaterial nachgerichtet werden kann. Bruchstücke, deren Größe die Grenzgröße unterschreiten, werden beispielsweise über ein Sieb aus einem nicht kontaminierenden Werkstoff von noch zu zerkleinerndem Halbleitermaterial getrennt. Mit einem optischen Zielerkennungssystem und Rechnerunterstützung kann in einer Ausbaustufe dieser Verfahrensvariante die Halbleiterzerkleinerung automatisiert werden.

In einer weiteren Ausführungsform des erfindungsgemäßen Verfahrens wird die Stoßwellenenergie über ein Wasserkissen in das Halbleitermaterial eingekoppelt. Die Zerkleinerung von Halbleiterkörpern muß hierbei nicht notwendigerweise, wie bisher dargestellt, unter Wasser erfolgen. Es genügt, beispielsweise einen mit Wasser gefüllten Kunststoffschlauch als Stoßwellenüberträger berührend zwischen die Schnittfläche des in diesem Fall flüssigkeitsdicht geschlossenen, wassergefüllten Halbellipsoidreflektors und die Halbleiteroberfläche zu bringen. Von besonderem Vorteil ist, daß dies in einem Reinraum oder auch unter Schutzgas durchgeführt werden kann, so daß das Risiko, das Halbleitermaterial beim Zerkleinern zu verunreinigen, weiter reduziert wird.

Das erfindungsgemäße Zerkleinerungsverfahren ist keinesfalls auf die eingangs erwähnten polykristallinen Siliciumstäbe beschränkt. Auf die dargestellte Weise können grundsätzlich massive, großvolumige Halbleiterkörper, bevorzugt aus mono- oder polykristallinem Silicium, zerkleinert werden.

Mit dem erfindungsgemäßen Verfahren gelingt es, Halbleitermaterial, insbesondere Silicium, bei niedrigen Temperaturen und ohne die Berührung eines Brechwerkzeugs zu zerkleinern. Die Zerkleinerung erfolgt ohne die Kontamination des Halbleitermaterials und ohne daß die Diffusion von oberflächlich adsorbierten Fremdstoffen, insbesondere Fremdmetallen, ins Innere der Bruchstücke durch hohe Temperaturen in Gang gesetzt und/oder beschleunigt wird. Bei fehlender oberflächlicher Verunreinigung des zu zerkleinernden Halbleitermaterials kann die bisher übliche Oberflächenreinigung der Bruchstücke durch Ätzen eingespart werden.

Das erfindungsgemäße Verfahren, Halbleitermaterial mittels Stoßwellen zu zerkleinern, wird im folgenden anhand eines Beispiels dargestellt. Das Beispiel dient nur zur näheren Erläuterung der Erfindung, ohne daß der Erfindungsgedanke damit eingeschränkt werden soll.

### Beispiel:

Aus einer Abscheideanlage stammende, polykristalline Stabstücke aus Silicium wurden vollständig in ein wassergefülltes Becken eingetaucht. Ihre Position im Becken war so gewählt, daß sie zumindest annähernd mit dem Fokussierungsbereich eines Halbellipsoidreflektors übereinstimmte. Der Halbellipsoidreflektor, in dessen Brennpunkt die Stoßwellen über elektrische Entladungen zwischen zwei Elektroden erzeugt wurden, war an einer Seitenwand des Wasserbeckens angeflanscht. Der Energieverbrauch bei der Stoßwellenerzeugung betrug 400 Joule pro Entladung. Die Entladungen wurden mit einer Frequenz von 0,5 bis 3 Hz durchgeführt und von einigen Sekunden bis zu zehn Minuten aufrechterhalten. Die den Stoßwellen ausgesetzten Stabstücke hatten Durchmesser von 100 bis 150 mm und Längen von 200 bis 500 mm. Die Behandlung führte je nach Dauer und Energieeintrag zu Bruchstücken unterschiedlicher Größe.

## Patentansprüche

1. Verfahren zum kontaminationsfreien Zerkleinern von Siliciumkörpern, dadurch gekennzeichnet, daß ein Siliciumkörper fokussierten Stoßwellen ausgesetzt wird, die im Brennpunkt eines Halbellipsoidreflektors erzeugt werden und die in einem flüssigen Medium auf den Siliciumkörper, der im Fokussierungsbereich des Haibellipsoidreflektors positioniert ist, übertragen werden.

2. Verfahren nach Anspruch 1, dadurch gekennzeichnet, daß die Stoßwellen in Wasser übertragen werden.

3. Verfahren nach Anspruch 1 oder Anspruch 2, dadurch gekennzeichnet, daß die Stoßwelien durch elektrische Entladung zwischen zwei Elektroden erzeugt werden.

4. Verfahren nach einem der Ansprüche 1 bis 3, dadurch gekennzeichnet, daß der Siliciumkörper vom Entstehungsort der Stoßwellen durch eine für Fremdstoffe undurchlässige Membran getrennt wird.

5. Verfahren nach einem der Ansprüche 1 bis 4, dadurch gekennzeichnet, daß der Siliciumkörper solange Stoßwellen ausgesetzt wird, bis er in Bruchstücke zerkleinert ist, die eine bestimmte Grenzgröße erreicht oder unterschritten haben.

## Claims

1. Method for the contamination-free size reduction of silicon bodies, characterized in that a silicon body is subjected to focused shock waves which are generated in the focal point of a semiellipsoidal reflector and which are transmitted in a liquid medium to the silicon body which is positioned in the focusing region of the semiellipsoidal reflector.

2. Method according to Claim 1, characterized in that the shock waves are transmitted in water.

3. Method according to Claim 1 or 2, characterized in that the shock waves are generated by electrical discharge between two electrodes.

4. Method according to any one of Claims 1 to 3, characterized in that the silicon body material is separated from the point of origin of the shock waves by a membrane which is impermeable to foreign substances.

5. Method according to any one of Claims 1 to 4, characterized in that the silicon body is subjected to shock waves until it is reduced in size to fragments which have reached a certain limiting size or dropped below it.

## Revendications

1. Procédé pour la fragmentation sans contamination d'objets à base de silicium, caractérisé en ce qu'on expose un objet à base de silicium aux ondes de choc focalisées, que l'on produit dans le foyer d'un reflecteur semi-ellipsoide et que l'on transfère dans un milieu liquide sur l'objet à base de silicium, qui est positionné dans la zone du foyer du réflecteur semi-ellipsoide.

2. Procédé selon la revendication 1, caractérisé en ce que les ondes de choc sont transférées dans l'eau.

3. Procédé selon la revendication 1 ou la revendication 2, caractérisé en ce que les ondes de choc sont produites par décharge électrique entre deux électrodes.

4. Procédé selon une ou plusieurs des revendications 1 à 3, caractérisé en ce que l'objet à base de silicium est séparé du lieu de production des ondes de choc par une membrane imperméable aux substances étrangères.

5. Procédé selon l'une des revendications 1 à 4, caractérisé en ce que l'objet à base de silicium est exposé aux ondes de choc jusqu'à ce qu'il soit fragmenté en fragments qui ont atteint une taille limite déterminée ou inférieure à celle-ci.
